Europäisches Patentamt

(19) European Patent Office

Office européen des brevets

(11) Publication number: **0 231 658**
B1

# EUROPEAN PATENT SPECIFICATION

(45) Date of publication of the patent specification:
18.07.90

(51) Int. Cl.⁵: **C30B 23/02**

(21) Application number: **86310149.9**

(22) Date of filing: **24.12.86**

(54) Molecular beam epitaxial apparatus.

(30) Priority: **27.12.85 JP 295296/85**

(43) Date of publication of application:
**12.08.87 Bulletin 87/33**

(45) Publication of the grant of the patent:
**18.07.90 Bulletin 90/29**

(84) Designated Contracting States:
**DE FR GB**

(56) References cited:
**FR-A- 2 511 709**

**PATENT ABSTRACTS OF JAPAN, vol. 10, no. 28 (C-326)[2085], 4th February 1986; & JP-A-60 180 997 (SHIMAZU SEISAKUSHO K.K.) 14.09.1985**

(73) Proprietor: **Kimata, Morihiko, 19-24 Tamako-cho 4-chome Higashi, Murayama-shi Tokyo(JP)**
Proprietor: **SHIMADZU CORPORATION, 378, Ichinofunairi-cho Kawaramachi-dori Nijo Sagaru, Nakagyo-ku Kyoto 604(JP)**

(72) Inventor: **Kimata, Morihiko, 19-24, Tamako-cho, 4-chome, Higashi Murayama-shi Tokyo(JP)**

(74) Representative: **Senior, Alan Murray et al, J.A. KEMP & CO 14 South Square Gray's Inn, London WC1R 5EU(GB)**

## Description

The present invention relates to a molecular beam epitaxial (MBE) apparatus.

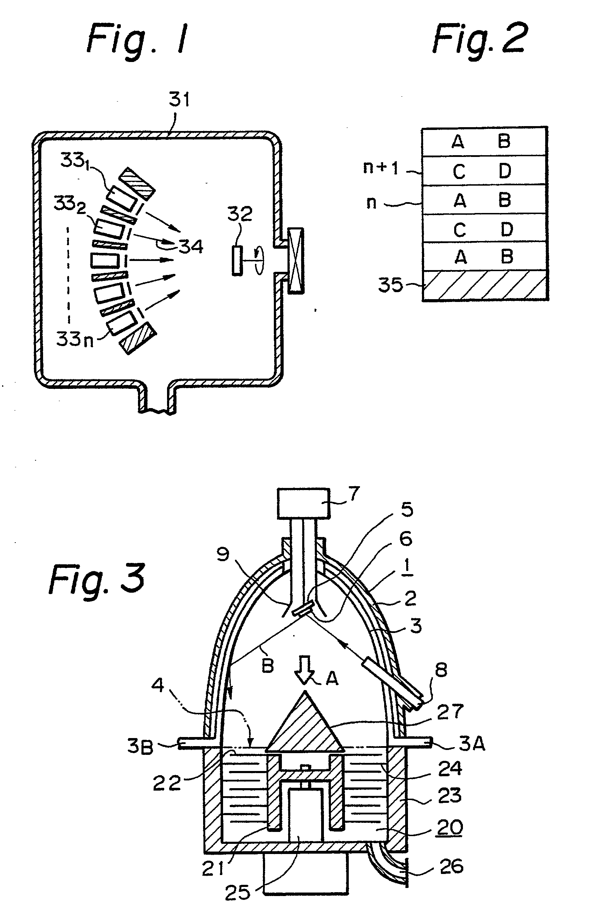

A molecular beam epitaxial apparatus for growing a crystal by irradiating molecules or atoms onto a crystalline substrate under a ultra-high vacuum (UHV) condition is known. A conventional molecular beam epitaxial apparatus is constructed in the following manner. Namely, as shown in Fig. 1, a crystalline substrate 32 is supported in a vacuum growth chamber 31. Furnaces $33_1$ to $33_n$ of a plurality of kinds of elements are provided for the substrate 32. An epitaxial layer is grown on the heated substrate 32 by directing the molecular beams from desired furnaces under UHV conditions. Such a molecular beam epitaxial apparatus has the feature that a combination of molecular beams can be varied by mechanical shutters, so that multiple layers of different kinds of compound crystals can be sequentially grown in a direction corresponding to the thickness of the substrate on an atomic layer unit basis.

In the conventional molecular beam epitaxial apparatus, in general, the degree of vacuum (partial pressure) deteriorates by one or two orders of magnitude for example, to the value of $10^{-9}$ to $10^{-8}$ Torr) during the growth of the crystal as compared with the degree of vacuum (total pressure) (e.g., $10^{-10}$ Torr) before the molecular flow is introduced for the crystal growth. This is because the molecular flow is introduced into the growth chamber 31 and added to the outgases in the growth chamber 31, so that the number of molecules to be exhausted increases.

Such a conventional MBE apparatus is unsuitable for forming a device having a multilayer structure of a compound semiconductor as shown in an example in Fig. 2. In Fig. 2, reference numeral 35 denotes a substrate and A, B, C, and D indicate component elements, respectively. The layer consisting of the compound AB and the layer consisting of the compound CD are alternately formed on the substrate 35. For example, the compound AB may be CdTe and the compound CD may be InSb. It is required that the heterojunction interface between the layer of the compound AB and the layer of the compound CD be formed in a stepwise manner. In the case of forming such a device, the elements (Cd and Te) which are necessary for the growth of the nth layer (e.g., CdTe layer) must not remain in the growth chamber when the (n+1)th layer (e.g., InSb layer) grows. For this purpose, the UHV needs to also be maintained during the crystal growth or the partial pressure of the component molecules of gases of the nth layer needs to rapidly decrease when the (n+1)th layer grows.

However, the conventional MBE apparatus has the drawback that it cannot satisfy the foregoing requirements since the degree of vacuum deteriorates during the crystal growth.

In addition, when the epitaxial layer grows on an atomic layer unit basis, it is undesirable that the growth rate varies with an elapse of time. However, the conventional MBE apparatus has another disadvantage such that the intensity of the molecular beam is temporarily increased when the shutter is made operative (ON).

In the following description, the term "molecules" is used as a general term including atoms, ions, and radicals as well as molecules.

According to one aspect of the present invention there is provided a particle beam deposition apparatus comprising:
a growth chamber having a sink opening for exhaustion of particles;
a particle beam source for directing a particle beam onto a substrate in said growth chamber, and a holder for the substrate which is arranged in the growth chamber in the direction of said particle beam characterised in that the chamber has a cooled inner wall and is shaped as a paraboloid of revolution such that the overall inner wall faces said sink opening and in that the holder has a structure and position such that the particle flow which is reflected from, or reevaporated after it has been adsorbed by, said substrate holder and substrate mounted thereon is directed to said sink opening.

In use, parts of the molecular beam or beams reflected or reevaporated from the substrate and the substrate holder are further reflected or reevaporated by the inner wall, so that a plurality of additional (i.e., secondary, ternary, ...) molecular beams are generated.

These additional molecular beams are also directed into the sink opening.

According to another aspect of the present invention there is provided a particle beam deposition apparatus comprising in combination:
a growth chamber having a first sink opening for exhaustion of particles
a particle beam source means for directing a particle beam onto a substrate in the growth chamber a holder for a substrate which is arranged in the growth chamber in the direction of the particle beam characterised in that the chamber has a cooled inner wall which is shaped such that all surface vectors of the overall inner wall are directed toward said first sink opening and in that said particle beam source means is located outside the growth chamber, and includes:
a particle beam source for generating a particle beam;
a beam source chamber for housing the particle beam source the beam source chamber being attached tangentially to the growth chamber, the adjoining walls of the growth chamber and the beam source chamber having aligned holes therein for leading the particle beam into said growth chamber, the beam source chamber including a second sink opening for exhaustion of particles and a second cooled inner wall which overall faces toward said second sink opening; and shutter means for selectively interrupting the flow of said particle beam and directing it toward the second sink opening.

With the invention, an auxiliary exhaust apparatus may be provided to ensure that the molecular beam portions which are unnecessary for the crystal growth, but which remain due to various attached apparatuses such as a substrate holding mechanism, apparatus for RHEED (reflection high energy electron diffraction), quadruple-mass spectrometer, and the like which are disposed in the growth chamber, are directed into the sink opening. This may comprise means for blowing a molecular flow having a relatively large ratio of specific heat toward the sink opening.

Further, when the shutters arranged in the growth chamber or molecular beam source chamber are in the inoperative (OFF) mode, the surface vectors of the reflecting surfaces of the shutters direct the molecular beam to the sink opening.

The inner wall of the growth chamber is normally formed of a paraboloid of revolution. However, the second aspect of the invention can also be applied to the case where the growth chamber is formed in a conical shape.

The molecular beam which is led into the growth chamber and irradiated onto the substrate contributes to the crystal growth. However, parts of the molecular beams are reflected or reevaporated by the substrate and the substrate holder, so that a secondary molecular flow is produced. Although almost all of the secondary molecular flow moves toward the sink opening, a part of the secondary molecular flow irradiates the inner wall. A part of the molecular flow reflected by the inner wall is further reflected once or a plurality of times and then moves toward the sink opening, while the other part is adsorbed by the inner wall. When the inner wall is cold, the reevaporation of the adsorbed molecules is suppressed.

In addition, an exhausing action is attained by the molecular flow which is reflected by the shutter in the OFF state and which moves toward the sink opening.

Conversely, the intensity of the molecular flow is maintained constant when the shutter is in the ON state.

The sink opening can be equipped with a vacuum pump such that reverse flow and reverse diffusion of the molecular flow to be exhausted do not occur. Molecular flow which is unnecessary for the crystal growth is discharged by the vacuum pump. This molecular flow also gives a kinetic energy to the residual molecules in the growth chamber (namely, the outgases from the inner wall and the like of the growth chamber and the gaseous molecules which were purposely led into the chamber for the preceding growth) so that they are directed toward the sink opening.

Thus, by executing the exhausting action for the residual molecules, the crystal component molecules locally increase in the molecular flow during the crystal growth, but the partial pressure of the background other than the molecular flow decreases.

The invention therefore decreases the deterioration in the degree of vacuum when the crystal grows and also reduces the variation in the intensity of the molecular beam with an elapse of time when the shutter is made operative.

The invention will be further described by way of non-limitative example with reference to the accompanying drawings, in which:

Fig. 1 is a schematic diagram for explaining a conventional molecular beam epitaxial apparatus;

Fig. 2 is a cross-sectional view of an example of a compound semiconductor which can be advantageously formed using the present invention;

Fig. 3 is a cross-sectional view of an embodiment of the present invention;

Fig. 4 is a schematic diagram for explaining the reevaporation of the adsorbed molecules;

Fig. 5 is a cross-sectional view of another embodiment of the invention;

Fig. 6 is a cross-sectional view of still another embodiment of the invention;

Fig. 7 is a horizontal cross-sectional view showing the arrangement of molecular beam sources in a modification of the Figure 6 embodiment of the invention; and

Figs. 8 and 9 are a vertical cross-sectional view and a horizontal cross-sectional view, respectively, of yet another embodiment of the invention.

In Fig. 3, reference numeral 1 denotes a growth chamber as a whole. The growth chamber 1 includes a hollow casing 2 having an inner wall shaped as a paraboloid of revolution. A shroud 3, similarly having an inner wall shaped as a paraboloid of revolution, is mounted coaxially with and next to the inner surface of the casing 2. The shroud 3 is formed with a lead-in port 3A of liquid nitrogen as a refrigerant and an exhaust port 3B for the gasified refrigerant.

The bottom portion of the growth chamber 1, namely, the plane perpendicular to the axis of the paraboloid of revolution is used as a sink opening 4 (indicated by a virtual line in the diagram). An intake port of a vacuum pump, for example, turbo molecular pump 20 is coupled with the sink opening 4. The pump 20 comprises: a rotary wing portion 22 in which a plurality of wings are attached at regular intervals on the outer peripheral surface of a cylindrical, rotary collar wheel 21; and fixed wings 24 attached on the inner peripheral surface of a cylindrical casing 23 at regular intervals in a manner such that the fixed wings 24 and the wings of the rotary wing portion 22 are alternately positioned. The intake port over the arrangement of the rotary wing portion 22 and fixed wings 24 is coupled with the sink opening 4 of the growth chamber 1.

When the rotary wing portion 22 of the pump 20 is rotated at a high speed by a motor 25, a suction is created in the direction from the intake port (sink opening 4 of the growth chamber 1) to an exhaust outlet 26. This produces an exhausting action in the direction from the top of the chamber to the sink opening 4 in the bottom, as indicated by an arrow A in the diagram. Although not shown, an auxiliary pump such as an oil rotating pump or the like is provided for the exhaust outlet 26.

A conical deflecting device 27 is arranged on the edge surface of the rotary collar wheel 21 of the pump 20. Although not shown, the surface of the deflecting device 27 is cooled by circulating a refrigerant such as liquid nitrogen or the like in the deflecting device 27. In the case of the turbo molecular pump, there exist portions having surface vectors having a polarity opposite to the exhausting direction. Therefore, the deflecting device 27 is provided to reduce the adverse influence of these portions. Namely, a reverse flow by the reflection of inflowing molecules at the edge surface of the rotary collar wheel 21 of the pump 20 is prevented by the deflecting device 27. Since the surface of the deflecting device 27 is cooled, the reevaporation of that portion of the molecules which were adsorbed is suppressed, so that the final degree of vacuum in the growth chamber 1 can be significantly raised compared to prior art such devices.

A substrate holder 5 is supported by a manipulator 7 at a location near the focal point of the growth chamber 1 of the paraboloid of revolution. The substrate holder 5 has a heater. A substrate 6 put on the substrate holder 5 is heated to a predetermined temperature. The molecular beam flows are emitted from a plurality of molecular beam sources 8 as narrow beams whose widths don't extend beyond the outside edges of the substrate holder 5. The molecular beam flows are irradiated onto the substrate 6. The substrate holder 5 is supported at an angle such that the reflecting direction of the incident molecular flow is directed to the sink opening 4. A flared reflecting plate 9 is arranged around the substrate holder 5 to allow the molecular flows which are reevaporated from the substrate 6 and substrate holder 5 to be directed toward the sink opening 4. A thin hole can be formed in the side surface of the reflecting plate 9 to allow an electron beam for the reflected electron beam diffraction (RHEED) to pass through this hole.

For the molecular beam sources 8, it is possible to use a source having a construction such that the molecular flows from a Knudsen cell or Langmuir cell, which use solid elements, are converged so as to be irradiated only onto the substrate 6. The number and kinds of molecular beam sources 8 can be arbitrarily set in accordance with the kinds of crystals to be grown. In the case of using a plurality of molecular beam sources 8, it is necessary to attach shutters to control the molecular beam sources so as to irradiate desired kinds of molecular beams onto the surface of the substrate 6 for a desired period of time. Gaseous elements may be also used as the molecular beam sources 8.

Parts of the molecular beams reflected or reevaporated from the substrate are further reflected or reevaporated by the inner wall, so that a plurality of additional (secondary, ternary, ...) molecular beams are generated. These additional molecular beams are also directed into the sink opening.

In the foregoing embodiment, in addition to the molecules which are purposefully emitted into the growth chamber 1 for the growth of the crystal, there is an unnecessary secondary molecular flow which is generated by reflection and reevaporation. However, the moving direction of the whole secondary molecular flow is directed to the sink opening 4 because of the paraboloid shape of the inner wall of the growth chamber 1. Namely, by setting the substrate 6 sample at the focal point of the paraboloid of revolution, the molecular flow can be moved toward the sink opening 4 by a single mirror reflection as indicated by an arrow B in Fig. 3 except the random reflection which is reflected in accordance with the cosine law. Therefore, in the growth chamber 1, the exhausting action is mainly performed in the direction from the chamber top to the exhaust port 4 in the bottom portion. Thus, a kinetic energy in the same direction as the exhausting direction is applied to the secondary molecular component. The residual gaseous molecules in the growth chamber 1 are effectively discharged by the secondary molecular flow in accordance with the principle of a vapor jet pump. To the extent that the secondary molecular flow is adsorbed by the inner wall, reevaporation must be suppressed by the cooled shroud 3, so that the components of the molecular flow in the direction opposite to the sink opening 4 are reduced and the final degree of vacuum can be further raised.

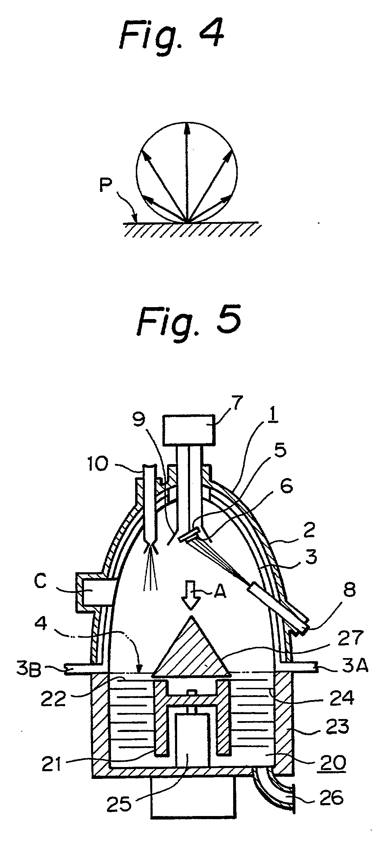

Namely, as shown in Fig. 4, upon reevaporation, molecules, which are proportional in number to the lengths of the vectors indicated by arrows in the diagram, are emitted from the evaporating surface P in various directions in accordance with the law of cosines. Since the reevaporated components include the components which don't move toward the sink opening, it is highly desirable to suppress the reevaporation by cooling the inner surface 3.

Fig. 5 shows another embodiment of the invention. In this embodiment, the growth chamber 1 and turbo molecular pump 20 are provided as in the foregoing embodiment. Those parts whose shapes differ from the shape of the inner wall of the growth chamber 1, can cause high molecular concentrations to be produced where the surface vectors are not directed to the sink opening 4 (namely, the parts whose shapes are not ideal such as the inner wall; for example, the attaching/detaching mechanism of the substrate 6, the apparatus necessary to evaluate the crystal, and the like).

In Fig. 5, a recess portion C is an example of the space within the chamber in which to locate some of the above-mentioned apparatuses. To prevent the occurrence of high molecular concentrations, a Laval nozzle exhaust mechanism 10 is mounted in the chamber wall above the recess C and is directed toward the sink opening 4 of the growth chamber 1 in order to spout out vapors having a large specific heat ratio, for example, mercury vapors at a sonic speed. However, when the speed of the wings of the turbo molecular pump is subsonic, the vapor speed needs to be reduced to a speed corresponding to the speed of the wings in order to prevent reverse diffusion.

A kinetic energy in the same direction as the exhausting direction is applied to the residual molecules in the growth chamber 1 by the vapors blown into the growth chamber 1, so that the remaining molecules in the growth chamber 1 are discharged. This raises the final degree of vacuum in the chamber.

In operation, when the chamber is used for epitaxial growth, the gases in the growth chamber 1 are discharged to create a vacuum, the refrigerant is filled in the shroud 3, and the substrate 6 is heated to a specified temperature by means of a heater (not shown) in the substrate holder 5. Thereafter, the molecular beams are emitted from the molecular beam sources 8 and irradiated onto the surface of the substrate 6, thereby allowing the crystals to grow. In this case, the kinds of molecular beams and the irradiating time periods are selectively controlled, thereby allowing the epitaxial layers of compounds to grow.

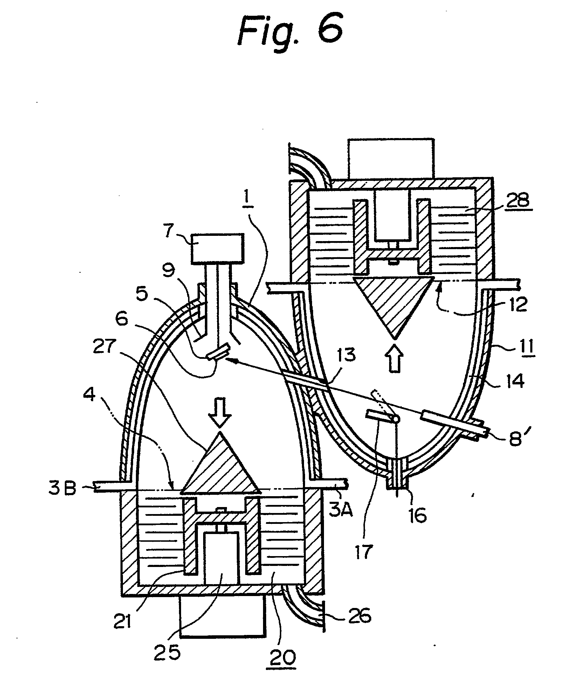

Fig. 6 shows still another embodiment of the invention, in which a beam source chamber 11 is provided independently of the growth chamber 1. The molecular flows from a plurality of molecular beam sources 8' are converged. The outgases from the crucible, heater, and heat shielding plate which constitute the molecular beam sources 8' and from their supporting members, and the unnecessary molecular flow are not led into the growth chamber.

As shown in Fig. 6, the beam source chamber 11 is arranged so as to be tangent to the growth chamber 1 by rotating another similar vacuum chamber by the angle of 180°. The beam source chamber 11 also has an inner wall shaped as a paraboloid of revolution similar to that of the growth chamber 1. A turbo molecular pump 28 is provided in a sink opening 12 (indicated by a virtual line in Fig. 6) of the opening plane of the bottom portion. The pump 28 has the same construction as the pump 20 provided in the sink opening 4 of the growth chamber 1. Therefore, in the beam source chamber 11, the exhausting action is attained in the direction indicated by the arrow from the chamber top to the sink opening 12. Similar to the above embodiment, a Laval nozzle exhaust mechanism may be also provided for the beam source chamber 11.

The molecular beam sources 8' arranged on the side of the beam source chamber 11 may be an ordinary Knudsen cell, Langmuir cell, or gas exhaust nozzle, or such a nozzle equipped with a cracking furnace. The molecular beam flows emitted from the molecular beam sources 8' are led into the growth chamber 1 through a plurality of holes 13 formed at the contact position between the growth chamber 1 and the beam source chamber 11 and are irradiated only onto the substrate 6. The unnecessary molecules of the molecular flows from the molecular beam sources 8' which don't pass through the holes 13 are reflected by the inner wall of a shroud 14 of the beam source chamber 11 or adsorbed to the inner wall of the shroud 14. The reflected or reevaporated molecules become a secondary molecular flow to which a kinetic energy is applied in the exhausting direction toward the sink opening 12. Therefore, the residual gaseous molecules in the chamber 11 are discharged by the secondary molecular flow in a manner similar to a vapor jet pump so that the beam source chamber 11 is held to an excellent vacuum state.

As in the case of individually providing shutters for a plurality of molecular beam sources 8', as shown in Fig. 6, shutters 17 can be provided. The on-off operations of these shutters for every molecular beam source can be controlled from the outside through rotary lead-in terminals 16. Each shutter 17 is formed of a tiltable plate made of, for example, molybdenum or the like. The state in which the shutter 17 is ON (namely, in the operative state) is shown in the diagram. In this operative state, the molecular flow is irradiated onto the substrate 6 in the growth chamber 1 through the holes 13. The shutter position shown in virtual line in Fig. 6 indicates the OFF state (i.e., inoperative state) of the shutters 17. In this inoperative state, the shutters 17 are attached at angles so as to deflect the reflected molecular flows toward the sink opening 12. Since adsorbed molecules are reevaporated in various directions on the basis of the law of cosines, the shutters 17 may be also cooled to prevent molecules from being adsorbed when the shutter is in the OFF state. The molecular flow reflected by the shutter 17 in the OFF state contributes to discharge the residual molecules in the beam source chamber 11.

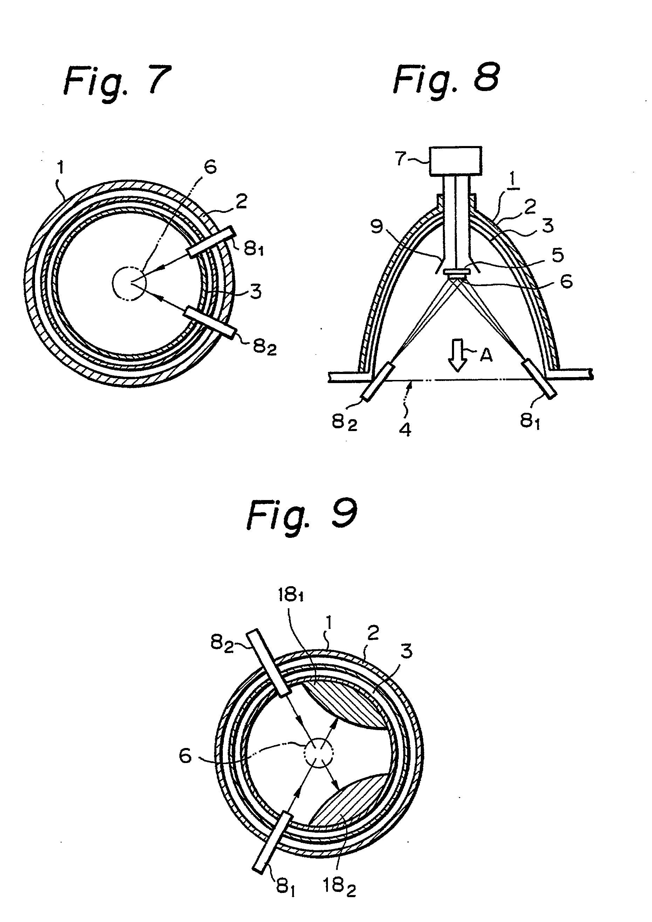

For the embodiments shown in Figs. 3 and 5, respectively, where a plurality of, for example, two molecular beam sources $8_1$ and $8_2$ are used in the growth chamber 1, they may be arranged as shown in Fig. 7. In the embodiment shown in Fig. 6, the holes 13 are formed at the positions to align with the molecular beam sources $8_1$ and $8_2$ as shown in Fig. 7. In such a multibeam source embodiment, the contact area between the growth chamber 1 and the beam source chamber 11 must be larger than for a single beams source embodiment.

Fig. 8 illustrates still another embodiment as an application of the invention in the case where a number of molecular beam sources are used. The growth chamber 1 is comprised of the casing 2 and the shroud 3, both of which have shapes which are paraboloids of revolution. In the example shown in Fig. 8, the substrate holder 5 is arranged in a plane which is parallel with the plane containing the sink opening 4. The molecular flows are irradiated onto the substrate 6 put on the substrate holder 5 from the molecular beam sources $8_1$ and $8_2$ arranged at substantially the same height positions as the sink opening 4, respectively. Since the substrate holder 5 is arranged in parallel with the sink opening 4, as shown in Fig. 9, to ensure that the molecular beam sources $8_1$ and $8_2$ are not polluted it is necessary that no other molecular beam sources be located in regions $18_1$ and $18_2$ into which the reflected molecular flows enter from the molecular beam sources $8_1$ and $8_2$, respectively.

In addition to the turbo molecular pump, it is also possible to use other vacuum pumps such as a diffusion pump, cryopump, or the like which can prevent the reevaporation of the molecular flow and reverse diffusion by reflection.

A sample preparation room and sample evaluation room which are separated by an air-lock mechanism can also be connected to the growth chamber 1. Further, it is also possible to install a nude ion gauge and a quadruple-mass spectrometer to measure the deposition rate (arrival rate), or a reflection high energy electron beam diffracting apparatus to evaluate the crystal during crystal growth, or the like.

According to the invention, the gases are discharged by using the portion of the molecular flow which is not used for the crystal growth. Therefore, the vacuum pump is constructed as a whole apparatus. As compared with a conventional molecular beam epitaxial apparatus, the discharging rate of the growth chamber can be increased and the degree of vacuum during the crystal growth can be greatly raised. In particular, a crystal having an excellent multilayer structure can be allowed to grow.

**Claims**

1. A particle beam deposition apparatus comprising:
a growth chamber (1) having a sink opening (4) for exhaustion of particles;
a particle beam source (8) for directing a particle beam onto a substrate (6) in said growth chamber, and a holder (5) for the substrate (6) which is arranged in the growth chamber in the direction of said particle beam characterised in that the chamber has a cooled inner wall (3) and is shaped as a paraboloid of revolution such that the overall inner wall faces said sink opening (4) and in that the holder has a structure and position such that the particle flow which is reflected from, or reevaporated after it has been adsorbed by, said substrate holder and substrate mounted thereon is directed to said sink opening (4).

2. A particle beam deposition apparatus according to claim 1 including shutter means for interrupting the particle beam and diverting it toward the sink opening (4).

3. A particle beam deposition apparatus comprising in combination:
a growth chamber (1) having a first sink opening (4) for exhaustion of particles
a particle beam source means for directing a particle beam onto a substrate (6) in the growth chamber a holder (5) for a substrate (6) which is arranged in the growth chamber in the direction of the particle beam characterised in that the chamber has a cooled inner wall (3) which is shaped such that all surface vectors of the overall inner wall are directed toward said first sink opening (4) and in that said particle beam source means is located outside the growth chamber, and includes:
a particle beam source (8') for generating a particle beam;
a beam source chamber (11) for housing the particle beam source (8') the beam source chamber being attached tangentially to the growth chamber, the adjoining walls of the growth chamber and the beam source chamber having aligned holes (13) therein for leading the particle beam into said growth chamber (1), the beam source chamber (11) including a second sink opening (12) for exhaustion of particles and a second cooled inner wall (14) which overall faces toward said second sink opening; and
shutter means (17) for selectively interrupting the flow of said particle beam and directing it toward the second sink opening.

4. A particle beam deposition apparatus according to claim 3, wherein the first cooled inner wall (3) is shaped as a paraboloid of revolution such that all surface vectors of said inner wall are directed toward said sink opening.

5. A particle beam deposition apparatus according to claims 1, 2 or 4 wherein the substrate holder holds the substrate at the focal point of said paraboloid of revolution.

6. A particle beam deposition apparatus according to claims 2, 3 or 4, wherein the shutter means is cooled to reduce reevaporation of particles adhering to it.

7. A particle beam deposition apparatus according to claim 2, 3, 4 or 6 wherein the shutter means comprises a flat plate and means for pivotally mounting the plate so that it can be moved between a closed position, interrupting the flow of the particle beam, and an open position which does not interrupt the flow.

8. A particle beam deposition apparatus according to any preceding claim further comprising means (10) for directing a particle flow having a relatively large ratio of specific heat toward the sink opening (4).

9. A particle beam deposition apparatus according to any preceding claim including turbo molecular pump means (20) including an exhaust outlet (26) and an inlet which is coupled to said sink opening, for applying a momentum to particles in the growth chamber.

10. A particle beam deposition apparatus as recited in claim 3 or any subsequent claim when dependent thereon, including turbo molecular pump means (28), including an exhaust outlet and an inlet which is coupled to said second sink opening, for applying a momentum to particles in the beam source chamber.

11. A particle beam deposition apparatus according to claim 8 or 9 wherein the molecular pump means (28, 20) comprises: a conical defecting device (27) arranged on the edge surface of a rotary collar wheel (21) having an outer peripheral surface, a plurality of rotary wings (22) which are attached at regular intervals on the outer peripheral surface of the collar wheel (21), a cylindrical casing (23) having an inner peripheral surface which surrounds the rotary wings (22), fixed wings (24) which are attached on the inner peripheral surface of the casing (23) at regular intervals in a manner such that the fixed wings (24) and the rotary wings (22) are alternately positioned, and means (25) for imparting rotation to the collar wheel (21) relative to the casing (23).

12. A particle beam deposition apparatus according to any preceding claim wherein the substrate holder holds the substrate parallel to the sink opening.

13. A particle beam deposition apparatus according to any preceding claim further comprising a plurality of particle beam sources ($8_1$, $8_2$) located to lead particle beams into the growth chamber (1) at the intersection of the sink opening (4) and the inner wall (3).

**Patentansprüche**

1. Teilchen-Strahlabscheidevorrichtung, die umfaßt: eine Wachstumskammer (1) mit einer Abzugsöffnung (4) zum Absaugen von Teilchen; eine Teilchen-Strahlquelle (8), um einen Teilchenstrahl auf ein Substrat (6) in der erwähnten Wachstumskammer zu richten, und einen Träger (5) für das Substrat (6), der in der Wachstumskammer in der Richtung des genannten Teilchenstrahls angeordnet ist, dadurch gekennzeichnet, daß die Kammer eine gekühlte Innenwand (3) hat und als ein Rotationsparaboloid ausgestaltet ist derart, daß die gesamte Innenwand der besagten Abzugsöffnung (4) gegenüberliegt, und daß der Träger einen Aufbau sowie eine Position hat derart, daß der Teilchenstrom, der von dem genannten Substratträger und dem daran angebrachten Substrat reflektiert oder, nachdem er von dem Substratträger und dem daran angebrachten Substrat adsorbiert worden ist, rückverdampft wird, zu der besagten Abzugsöffnung (4) gerichtet wird.

2. Teilchen-Strahlabscheidevorrichtung nach Anspruch 1, die Klappeneinrichtungen enthält, um den Teilchenstrahl zu unterbrechen und diesen zu der Abzugsöffnung (4) hin abzulenken.

3. Teilchen-Strahlabscheidevorrichtung, die in Kombination umfaßt: eine Wachstumskammer (1) mit einer ersten Abzugsöffnung (4) zum Absaugen von Teilchen, eine Teilchen-Strahlquelleneinrichtung, um einen Teilchenstrahl auf ein Substrat (6) in der Wachstumskammer zu richten, und einen Träger (5) für ein Substrat (6), der in der Wachstumskammer in der Richtung des Teilchenstrahls angeordnet ist, dadurch gekennzeichnet, daß die Kammer eine gekühlte Innenwand (3) hat, die derart ausgestaltet ist, daß alle Flächenvektoren der gesamten Innenwand zu der genannten ersten Abzugsöffnung (4) hin gerichtet sind, und daß die erwähnte Teilchen-Strahlquelleneinrichtung außenseitig der Wachstumskammer angeordnet ist sowie umfaßt eine Teilchen-Strahlquelle (8') zur Erzeugung eines Teilchenstrahls; eine Strahlquellenkammer (11) zur Aufnahme der Teilchenstrahlquelle (8'), wobei die Strahlquellenkammer tangential an der Wachstumskammer angebracht ist, die aneinandergrenzenden Wände der Wachstumskammer sowie der Strahlquellenkammer fluchtende Öffnungen (13) in diesen aufweisen, um den Teilchenstrahl in die besagte Wachstumskammer (1) zu leiten, die Strahlquellenkammer (11) eine zweite Abzugsöffnung (12) zum Absaugen von Teilchen sowie eine zweite gekühlte Innenwand (14) aufweist, die insgesamt zu der genannten zweiten Abzugsöffnung hin gegegenüberliegt, und Klappeneinrichtungen (17), um selektiv den Fluß des erwähnten Teilchenstroms zu unterbrechen sowie diesen zur zweiten Abzugsöffnung hin zu richten.

4. Teilchen-Strahlabscheidevorrichtung nach Anspruch 3 , wobei die erste gekühlte Innenwand (3) als Rotationsparaboloid ausgebildet ist derart, daß alle Flächenvektoren der genannten Innenwand zu der erwähnten Abzugsöffnung hin gerichtet sind.

5. Teilchen-Strahlabscheidevorrichtung nach Anspruch 1, 2 oder 4, wobei der Substratträger das Substrat im Brennpunkt des genannten Rotationsparaboloids hält.

6. Teilchen-Strahlabscheidevorrichtung nach Anspruch 2, 3 oder 4, wobei die Klappeneinrichtungen gekühlt sind, um eine Rückverdampfung von daran haftenden Teilchen zu vermindern.

7. Teilchen-Strahlabscheidevorrichtung nach Anspruch 2, 3 oder 6, wobei die Klappeneinrichtungen eine flache Platte sowie Mittel zur schwenkbaren Lagerung der Platte umfassen, so daß diese zwischen einer den Fluß des Teilchenstrahls unterbrechenden Absperrposition und einer offenen, den Fluß nicht unterbrechenden Position bewegt werden kann.

8. Teilchen-Strahlabscheidevorrichtung nach irgendeinem vorhergehenden Anspruch, die des weiteren Einrichtungen (10) umfaßt, um einen Teilchenstrom, der ein relativ großes Verhältnis an spezifischer Hitze hat, zu der Abzugsöffnung (4) zu richten.

9. Teilchen-Strahlabscheidevorrichtung nach irgendeinem vorhergehenden Anspruch, die eine Turbo-Molekularpumpeinrichtung (20) mit einem Absaugauslaß (26) und einem Einlaß, der mit der besagten Abzugsöffnung gekoppelt ist, umfaßt, um den Teilchen in der Wachstumskammer einen Impuls zu vermitteln.

10. Teilchen-Strahlabscheidevorrichtung nach Anspruch 3 oder irgendeinem folgenden Anspruch bei Abhängigkeit von diesem, die eine Turbo-Molekularpumpeinrichtung (28) mit einem Absaugauslaß und einem Einlaß, der mit der besagten zweiten Abzugsöffnung gekoppelt ist, umfaßt, um den Teilchen in der Strahlquellenkammer einen Impuls zu vermitteln.

11. Teilchen-Strahlabscheidevorrichtung nach Anspruch 8 oder 9, wobei die Molekularpumpeinrichtung (28, 20) umfaßt: eine kegelförmige Ablenkvorrichtung (27), die an der Stirnfläche eines drehenden Ringbundrades (21), das mit einer Außenumfangsfläche versehen ist, angeordnet ist, eine Mehrzahl von drehenden Flügeln (22), die in regelmäßigen Abständen an der Außenumfangsfläche des Ringbundrades (21) angebracht sind, ein zylindrisches Gehäuse (23) mit einer die drehenden Flügel (22) umgebenden Innenumfangsfläche, ortsfeste Flügel (24), die an der Innenumfangsfläche des Gehäuses (23) in regelmäßigen Abständen derart angebracht sind, daß die ortsfesten Flügel (24) sowie die drehenden Flügel (22) abwechselnd angeordnet sind, und eine Einrichtung (25), um dem Ringbundrad (21) eine Drehung mit Bezug zum Gehäuse (23) zu vermitteln.

12. Teilchen-Strahlabscheidevorrichtung nach irgendeinem vorhergehenden Anspruch, wobei der Substratträger das Substrat parallel zur Abzugsöffnung hält.

13. Teilchen-Strahlabscheidevorrichtung nach irgendeinem vorhergehenden Anspruch, die ferner eine Mehrzahl von Teilchen-Strahlquellen ($8_1$, $8_2$) umfaßt, die angeordnet sind, um Teilchenstrahlen in die Wachstumskammer (1) an der Schnittstelle der Abzugsöffnung (4) und der Innenwand (3) zu richten.

**Revendications**

1. Dispositif de dépôt par faisceau de particules comportant:
une chambre de croissance (1) possédant une ouverture d'évacuation (4) pour l'échappement de particules;
une source de faisceau de particules (8) pour diriger un faisceau de particules sur un substrat (6) dans ladite chambre de croissance, et un support (5) pour le substrat (6) qui est disposé dans la chambre de croissance dans la direction dudit faisceau de particules, caractérisé en ce que la chambre possède une paroi interne refroidie (3) et a la forme d'un paraboloïde de révolution de telle sorte que la totalité de la paroi interne soit tournée vers ladite ouverture d'évacuation (4) et en ce que le support possède une structure et une position telles que le flux de particules qui est réfléchi depuis, ou réévaporé après avoir été adsorbé par ledit support de substrat et le substrat monté sur celui-ci, est dirigé vers ladite ouverture d'évacuation (4).

2. Dispositif de dépôt par faisceau de particules selon la revendication 1, comprenant des moyens formant obturateur pour interrompre le faisceau de particules et le dévier vers l'ouverture d'évacuation (4).

3. Dispositif de dépôt par faisceau de particules comportant en combinaison:
une chambre de croissance (1) possédant une première ouverture d'évacuation (4) pour l'échappement de particules
des moyens formant une source de faisceau de particules pour diriger un faisceau de particules sur un substrat (6) dans la chambre de croissance, un support (5) pour un substrat (6) qui est disposé dans la chambre de croissance dans la direction du faisceau de particules, caractérisé en ce que la chambre possède une paroi intérieure refroidie (3) qui est conformée de telle sorte que tous les vecteurs de surface de la totalité de la paroi intérieure soient dirigés vers ladite première ouverture d'évacuation (4) et en ce que lesdits moyens formant une source de faisceau de particules sont disposés à l'extérieur de la chambre de croissance, et comprennent:
une source de faisceau de particules (8') pour produire un faisceau de particules;
une chambre (11) de source de faisceau pour loger la source de faisceau de particules (8'), la chambre de la source de faisceau étant fixée tangentiellement à la chambre de croissance, les parois adjacentes de la chambre de croissance et de la chambre de source de faisceau possédant des trous alignés (13) pour acheminer le faisceau de particules dans ladite chambre de croissance (1), la chambre de source de faisceau (11) comprenant une seconde ouverture d'évacuation (12) pour l'échappement de particules et une seconde paroi intérieure refroidie (14) faisant face globalement vers ladite seconde ouverture d'évacuation; et des moyens (17) formant obturateur pour interrompre sélectivement le flux dudit faisceau de particules et le diriger vers ladite seconde ouverture d'évacuation.

4. Dispositif de dépôt par faisceau de particules selon la revendication 3, dans lequel la première paroi intérieure refroidie (3) est en forme de paraboloïde de révolution de telle sorte que tous les vecteurs de surface de ladite paroi intérieure soient dirigés vers ladite ouverture d'évacuation.

5. Dispositif de dépôt par faisceau de particules selon les revendications 1, 2 ou 4, dans lequel le porte-substrat supporte le substrat au point focal dudit paraboloïde de révolution.

6. Dispositif de dépôt par faisceau de particules selon les revendications 2, 3 ou 4, dans lequel les moyens formant obturateur sont refroidis pour réduire une réévaporation de particules y adhérant.

7. Dispositif de dépôt par faisceau de particules selon la revendication 2, 3, 4 ou 6, dans lequel les moyens formant obturateur comportent une plaque plane et des moyens pour supporter à pivotement la plaque de telle sorte qu'elle puisse être déplacée entre une position fermée, interrompant le flux du faisceau de particules, et une position ouverte qui n'interrompt pas le flux.

8. Dispositif de dépôt par faisceau de particules selon l'une quelconque des revendications précédentes, comportant en outre des moyens (10) pour diriger un flux de particules possédant un rapport de chaleur spécifique relativement grand vers l'ouverture d'évacuation (4).

9. Dispositif de dépôt par faisceau de particules selon l'une quelconque des revendications précédentes, comprenant des moyens (20) formant pompe turbomoléculaire comprenant un orifice d'échappement (26) et un orifice d'admission qui est relié à ladite ouverture d'évacuation pour appliquer un moment aux particules dans la chambre de croissance.

10. Dispositif de dépôt par faisceau de particules selon la revendication 3 ou l'une quelconque des revendications suivantes lorsqu'elle est rattachée à celle-ci, comprenant des moyens (28) formant pompe turbomoléculaire, comprenant un orifice d'échappement et un orifice d'admission qui est relié à ladite seconde ouverture seconde ouverture d'évacuation, pour appliquer un moment aux particules dans la chambre de source de faisceau.

11. Dispositif de dépôt par faisceau de particules selon la revendication 8 ou 9, dans lequel les moyens (28, 20) formant pompe moléculaire comportent: un dispositif de déviation conique (27) disposé sur la surface de bord d'une roue à collier rotative (21) possédant une surface périphérique extérieure; une pluralité d'ailettes rotatives (22) qui sont fixées à des intervalles réguliers sur la surface périphérique extérieure de la roue à collier (21), un boîtier cylindrique (23) possédant une surface périphérique intérieure entourant les ailettes rotatives (22), des ailettes fixes (24) fixées sur la surface périphérique intérieure du boîtier (23) à des intervalles réguliers de telle manière que les ailettes fixes (24) et les ailettes rotatives (22) soient disposées alternativement, et des moyens (25) pour conférer une rotation à la roue à collier (21) par rapport au boîtier (23).

12. Dispositif de dépôt par faisceau de particules selon l'une quelconque des revendications précédentes, dans lequel le porte-substrat supporte le substrat parallèlement à l'ouverture d'évacuation.

13. Dispositif de dépôt par faisceau de particules selon l'une quelconque des revendications précédentes, comportant en outre une pluralité de sources de faisceaux de particules (8₁, 8₂) disposées pour acheminer les faisceaux de particules dans la chambre de croissance (1) à l'intersection de l'ouverture d'évacuation (4) et de la paroi intérieure (3).

*Fig. 1*

*Fig. 2*

*Fig. 3*

# Fig. 4

# Fig. 5

# Fig. 6

EP 0 231 658 B1

Fig. 7

Fig. 8

Fig. 9